**Europäisches Patentamt**

**European Patent Office**

**Office européen des brevets**

(11) Veröffentlichungsnummer: **0 072 478**
**B1**

(12) # EUROPÄISCHE PATENTSCHRIFT

(45) Veröffentlichungstag der Patentschrift:
**07.10.87**

(51) Int. Cl.⁴: **H 01 L 23/56, H 01 L 25/10**

(21) Anmeldenummer: **82106925.9**

(22) Anmeldetag: **30.07.82**

(54) Hochspannungsgleichrichter.

(30) Priorität: **19.08.81 DE 3132791**

(43) Veröffentlichungstag der Anmeldung:
**23.02.83 Patentblatt 83/8**

(45) Bekanntmachung des Hinweises auf die Patenterteilung:
**07.10.87 Patentblatt 87/41**

(84) Benannte Vertragsstaaten:
**CH DE FR GB LI SE**

(56) Entgegenhaltungen:
**DE - A - 1 763 840**
**DE - A - 1 789 139**
**FR - A - 2 335 989**
**GB - A - 2 042 261**
**US - A - 3 848 174**

(73) Patentinhaber: **Siemens Aktiengesellschaft Berlin und München, Wittelsbacherplatz 2, D-8000 München 2 (DE)**

(72) Erfinder: **Bahlinger, Walter, Ed.-Schenkstrasse 68, D-8000 München 40 (DE)**

ACTORUM AG

## Beschreibung

Die Anmeldung bezieht sich auf einen Hochspannungsgleichrichter mit einer Vielzahl von in Reihe geschalteten Halbleiterbauelementen, mit einer im wesentlichen zylindrischen Abschirmung, die aus mehreren elektrisch gegeneinander isolierten Abteilungen besteht, wobei jede Abteilung mindestens ein Halbleiterbauelement enthält.

Ein solcher Hochspannungsgleichrichter ist beispielsweise in der DE-A-23 42 772 beschrieben worden. Die Halbleiterbauelemente befinden sich im Inneren der Abschirmung, wo sie auf speziellen Trägern montiert sind. Der beschriebene Hochspannungsgleichrichter ist für relativ kleine Ströme ausgelegt, so dass besondere Massnahmen zur Kühlung nicht erforderlich sind. Für höhere Ströme müssen die Halbleiterbauelemente aber im allgemeinen durch Kühlkörper gekühlt werden.

Der Erfindung liegt die Aufgabe zugrunde, einen Hochspannungsgleichrichter der erwähnten Art so weiterzubilden, dass er mit geringem Aufwand auch für Halbleiterbauelemente höherer Leistung verwendbar ist.

Die Erfindung ist dadurch gekennzeichnet, dass die Abteilungen der Abschirmung als Kühlkörper ausgebildet sind, dass eine Seite der Kühlkörper von einer Zylinderabschnittsfläche begrenzt ist, dass mindestens zwei der Kühlkörper zu einer Gruppe zusammengefasst und in ein und derselben Ebene im Abstand voneinander derart angeordnet sind, dass ihre Zylinderabschnittsflächen einen nahezu vollständig geschlossenen Zylinder ergeben, dass die Kühlkörper auf der der Zylinderabschnittsfläche gegenüberliegenden Seite mit Kühlrippen versehen sind und dass mit dieser Seite mindestens eines der Halbleiterbauelemente thermisch und elektrisch leitend verbunden ist.

Die Erfindung wird an Hand eines Ausführungsbeispiels in Verbindung mit den Fig. 1 bis 3 näher erläutert. Es zeigen:

Fig. 1 einen Schnitt durch einen Hochspannungsgleichrichter gemäss der Erfindung,

Fig. 2 eine Ansicht des Hochspannungsgleichrichters in Richtung des Pfeils A der Fig. 1 und

Fig. 3 eine Ansicht des Hochspannungsgleichrichters in Richtung des Pfeils B der Fig. 1.

Gleiche Teile sind in allen Figuren mit gleichen Bezugszeichen versehen.

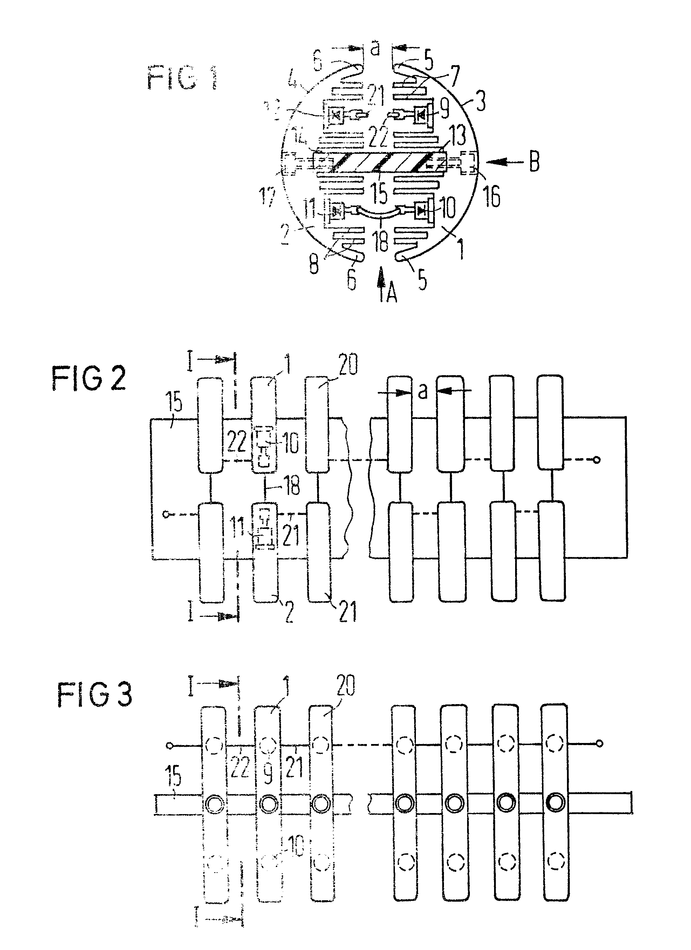

Die Fig. 1 zeigt zwei Kühlkörper 1 und 2, die einander gegenüberliegend in ein und derselben Ebene angeordnet sind. Die Kühlkörper 1, 2 werden aussen durch Zylinderabschnittsflächen 3, 4 begrenzt, die jeweils nahezu einen Halbzylinder umfassen. Die Kühlkörper sind in einem Abstand a voneinander montiert und bilden zusammen einen nahezu vollständig geschlossenen Zylinder. «Nahezu vollständig geschlossen» bedeutet in diesem Zusammenhang, dass die Fläche nur insoweit unterbrochen ist, als dies zur elektrischen Isolation der auf verschiedenen Potentialen liegenden Kühlkörper 1 und 2 notwendig ist. Auf der den Zylinderabschnittsflächen 3, 4 gegenüberliegenden Seiten der Kühlkörper sind Kühlrippen 7 bzw. 8 angebracht. Die am weitesten aussenliegenden Kühlrippen sind mit 5 bzw. 6 bezeichnet. Sie sind an ihrem Ende derart abgerundet, dass hier bei Anlegen der Betriebsspannung keine Sprüh- oder Entladungserscheinungen auftreten. Mit der die Kühlrippen tragenden Seite der Kühlkörper sind Halbleiterbauelemente 9, 10 bzw. 11, 12 z.B. durch Einschrauben elektrisch und thermisch leitend verbunden. Die Halbleiterbauelemente sind beispielsweise Dioden oder Thyristoren. Die die Kühlrippen tragende Seite der Kühlkörper sind mit je einer Aussparung 13 bzw. 14 versehen, in die ein Isolierkörper, beispielsweise eine Leiste 15, hineinragt. Beide Kühlkörper werden mit Schrauben 16 bzw. 17 an der Leiste 15 befestigt.

Wie aus Fig. 2 und 3 zu ersehen, sind je nach Höhe der gleichzurichtenden Spannung auf der Leiste 15 mehrere Gruppen von Kühlkörpern angeordnet. Zwei weitere der zu einer Gruppe gehörenden Kühlkörper sind mit 20, 21 bezeichnet. Dabei sind die Halbleiterbauelemente jeder Gruppe elektrisch hintereinandergeschaltet. Die Dioden der vorausgehenden Gruppe sind dann mit denen der folgenden Gruppe in Reihe geschaltet. Die Halbleiterbauelemente 10, 11 sind durch eine Leitung 18 verbunden, während die Halbleiterbauelemente 9, 10 und 11, 12 durch den Kühlkörper 1 bzw. 2 verbunden sind. Die Gruppen sind dann ihrerseits untereinander durch Leitungen 21 und 22 verbunden. Es ist ersichtlich, dass die Halbleiterbauelemente völlig und die Leitungen wenigstens teilweise innerhalb des durch die Flächen 3 und 4 gebildeten Zylinders liegen. Der Abstand der einzelnen Gruppen von Kühlkörpern ist wiederum durch die Höhe der Betriebsspannung bestimmt. Er kann daher wiederum a betragen. Die Abschirmfähigkeit der Kühlkörper wird durch die Unterbrechung mit dem Abstand a nicht beeinträchtigt, sie wirken wie ein Faraday'scher Käfig.

In Fig. 1 wurde dargestellt, dass eine in ein und derselben Ebene angeordnete Gruppe aus zwei Kühlkörpern besteht. Es ist jedoch auch möglich, mehrere, z.B. drei oder vier, Kühlkörper in ein und derselben Ebene so anzuordnen, dass ihre Zylinderabschnittsflächen einen nahezu vollständigen Zylinder ergeben. Diese drei oder vier Kühlkörper werden dann durch entsprechend geformte Leisten mechanisch miteinander verbunden.

## Patentansprüche

1. Hochspannungsgleichrichter mit einer Vielzahl von in Reihe geschalteten Halbleiterbauelementen, mit einer im wesentlichen zylindrischen Abschirmung, die aus mehreren elektrisch gegeneinander isolierten Abteilungen besteht, wobei jede Abteilung mindestens ein Halbleiterbauelement enthält, dadurch gekennzeichnet, dass die Abteilungen der Abschirmung als Kühlkörper (1, 2) ausgebildet sind, dass eine Seite der Kühlkörper von einer Zylinderabschnittsfläche (3, 4) begrenzt ist, dass mindestens zwei der Kühlkörper zu einer Gruppe zusammengefasst und in ein und derselben Ebene im Abstand (a) voneinander derart angeordnet sind, dass ihre Zylinderabschnittsflächen (3, 4) einen nahezu vollständig geschlossenen Zylinder ergeben, dass die Kühlkörper auf der der Zylinderabschnittsfläche gegenüberliegenden Seite mit Kühlrippen (5, 6, 7, 8) versehen sind und dass mit dieser Seite mindestens eines der Halbleiterbauelemente (9, 10, 11, 12) thermisch und elektrisch leitend verbunden ist.

2. Hochspannungsgleichrichter nach Anspruch 1, dadurch gekennzeichnet, dass die Kühlkörper auf der die Kühlrippen tragenden Seite mit einer Aussparung (13, 14) versehen sind, und dass die Kühlkörper (1, 2) durch einen in der Aussparung befestigten Isolierkörper (15) mechanisch miteinander verbunden sind.

3. Halbleiterbauelement nach Anspruch 2, dadurch gekennzeichnet, dass der Isolierkörper eine Leiste ist, auf dem mehrere Gruppen von Kühlkörpern (1, 2; 20, 21) im Abstand voneinander befestigt sind.

4. Halbleiterbauelement nach Anspruch 3, dadurch gekennzeichnet, dass die Halbleiterbauelemente der Gruppen durch im wesentlichen innerhalb der Zylinderflächen liegende Leiter (18, 21, 22) elektrisch miteinander verbunden sind.

## Claims

1. A high voltage rectifier comprising a plurality of series-connected semiconductor components, with a basically cylindrical screening consisting of a plurality of divisions which are electrically insulated from one another, each division containing at least one semiconductor component, characterised in that the divisions of the screening consists of cooling bodies (1, 2); that one side of the cooling bodies is delimited by a surface in the form of a cylinder segment (3, 4); that at least two of the cooling bodies are combined to form a group and are arranged in one and the same plane at a distance (a) from one another, in such manner that their cylinder segment surfaces (3, 4) form an almost completely closed cylinder; that on the side opposite the cylinder segment surface, the cooling bodies are provided with cooling ribs (5, 6, 7, 8), and that this side is thermally and electrically conductively connected to at least one of the semiconductor components (9, 10, 11, 12).

2. A high voltage rectifier as claimed in Claim 1, characterised in that on the side which carries the cooling ribs, the cooling bodies are provided with a recess (13, 14) and that the cooling bodies (1, 2) are mechanically connected to one another by means of an insulating body (15) secured in the recess.

3. A semiconductor component as claimed in Claim 2, characterised in that the insulating body is a strip on which a plurality of groups of cooling bodies (1, 2; 20, 21) are secured spaced at intervals from one another.

4. A semiconductor component as claimed in Claim 3, characterised in that the semiconductor components of the groups are electrically connected to one another by means of conductors (18, 21, 22) which are essentially located in the cylinder surfaces.

## Revendications

1. Redresseur à haute tension comportant une multiplicité de composants à semiconducteurs branchés en série et un blindage essentiellement cylindrique, qui est constitué par plusieurs compartiments isolés électriquement les uns par rapport aux autres, chaque compartiment contenant au moins un composant à semiconducteurs, caractérisé par le fait que les compartiments du blindage sont réalisés sous la forme de dissipateurs de chaleur (1, 2), qu'une face des dissipateurs de chaleur est limitée par un élément de surface cylindrique (3, 4), qu'au moins deux des dissipateurs de chaleur sont réunis pour former un groupe et sont disposés dans un même plan à une distance (a) l'un de l'autre de telle sorte que leurs éléments de surface cylindrique (3, 4) forment un cylindre presque complètement fermé, que les dissipateurs de chaleur comportent des nervures de refroidissement (5, 6, 7, 8) sur la face située en vis-à-vis de l'élément de surface cylindrique et qu'au moins l'un des composants à semiconducteurs (9, 10, 11, 12) est relié d'une façon conductrice du point de vue thermique et électrique à cette face.

2. Redresseur à haute tension suivant la revendication 1, caractérisé par le fait que les dissipateurs de chaleur comportent, sur la face portant les nervures de refroidissement, un évidement (13, 14) et que les dissipateurs de chaleur (1, 2) sont reliés mécaniquement entre eux par un corps isolant (15) fixé dans l'évidement.

3. Composant à semiconducteurs suivant la revendication 2, caractérisé par le fait que le corps isolant est une barrette sur laquelle plusieurs groupes de dissipateurs de chaleur (1, 2; 20, 21) sont fixés à une distance les uns des autres.

4. Composant à semiconducteurs suivant la revendication 3, caractérisé par le fait que les composants à semiconducteurs des groupes sont reliés électriquement entre eux par des conducteurs (18, 21, 22) situés essentiellement à l'intérieur des surfaces cylindriques.

FIG 1

FIG 2

FIG 3